# EUROPEAN PATENT SPECIFICATION

(11) **EP 3 978 298 B1**
(45) Date of publication and mention of the grant of the patent: **26.04.2023**
(21) Application number: 21186963.1
(22) Date of filing: 21.07.2021
(51) Int. Cl.: B60K 37/06, H05K 1/14

(54) **DISPLAY APPARATUS**
ANZEIGEVORRICHTUNG
APPAREIL D'AFFICHAGE

(30) Priority: 30.09.2020 JP 2020166173
(43) Date of publication of application: 06.04.2022
(73) Proprietor: Yamaha Hatsudoki Kabushiki Kaisha, Iwata-shi, Shizuoka 438-8501 (JP)
(72) Inventor: Sugiyama, Yuichi, Shizuoka, 4388501 (JP)
(74) Representative: Grünecker Patent- und Rechtsanwälte PartG mbB

(56) References cited:
- WO-A1-2015/076143
- US-A1- 2018 215 435

## Description

The present invention relates to a display apparatus according to the preamble of independent claim 1, a straddled vehicle having a display apparatus and a display means comprising a display apparatus and a portable terminal. Such a display apparatus can be taken from the prior art document WO 2015/076143 A1.

JP-A-2014-116554 discloses a vehicle display apparatus where a pointer display portion for displaying a traveling speed value of a vehicle and an image display portion for displaying an image about vehicle information such as an accumulated mileage or fuel consumption are mounted on one and the same circuit board.

In recent years, not only information indicating a traveling state of a vehicle (such as vehicle speed information) but also infotainment information (such as road traffic information) is often displayed on a display portion of a display apparatus mounted on a straddled vehicle. For this reason, the number of components provided in the display apparatus mounted on the straddled vehicle tends to increase. When a large number of components are disposed on one and the same board, the size of the board needs to be increased from a viewpoint of a region where the components can be disposed or from a viewpoint of keeping a certain distance between adjacent ones of the components in order to prevent a specific component from damaging another component due to heat dissipated from the specific component. However, when the size of the board is increased, the size of the display apparatus is also increased. As a result, the degree of freedom for design of the straddled vehicle may be decreased.

Further, in a background-art display apparatus, a display panel for displaying vehicle speed information or the like and a display panel for displaying infotainment information are designed as one module. For this reason, the entire module in the background-art display apparatus is newly designed according to each straddled vehicle. Therefore, the background-art display apparatus increases the number of development steps or prolongs a development period. As a result, overall manufacturing cost may increase. In these respects, the background-art display apparatus has room for improvement.

An object of the present invention is to provide a display apparatus that is mounted on a straddled vehicle, and that is compact and high in degree of freedom for design without reducing the number of components that can be mounted on the display apparatus. According to the present invention said object is solved by a display apparatus having the features of independent claim 1. Preferred embodiments are laid down in the dependent claims.

Accordingly, it has examined a display apparatus that has a small number of development steps and a short development period while achieving a high degree of freedom for design. Infotainment information is information received from a communication terminal and has low relevance to designability of a straddled vehicle in the display apparatus. Therefore, it can be noticed that a display panel for displaying the infotainment information can be also used for different vehicle models. In other words, it can be noticed that, of a display panel for displaying a meter display picture and the display panel for displaying the infotainment information, which display panels have been designed as one module in the background art, the latter has high versatility. Therefore, there is an idea that by designing the two display panels as independent modules and combining them, it is possible to manufacture a display apparatus that has a small number of development steps and a short development period while achieving a high degree of freedom for design.

According to one or more aspects of the present invention there is provided a display apparatus which is to be mounted on a straddled vehicle and communicably connected to a portable terminal.

The display apparatus comprises:
a meter display module comprising:
   a first circuit board;
   a first display panel disposed on the first circuit board and configured to display a meter display picture indicating a traveling state of the straddled vehicle; and
   a first control unit disposed on the first circuit board and configured to control the first display panel; and
an infotainment display module comprising:
   a second circuit board;
   a second display panel disposed on the second circuit board and configured to display infotainment information transmitted from the portable terminal; and
   a second control unit disposed on the second circuit board and configured to control the second display panel, and
a communication module disposed on the second circuit board and communicably connected to the portable terminal.

The second circuit board is mounted on the first circuit board.

According to the aforementioned configuration, the first control unit that can control the first display panel is disposed on the first circuit board provided in the meter display module, and the second control unit that can control the second display panel is disposed on the second circuit board provided in the infotainment display module. That is, the meter display module and the infotainment display module are modules independent of each other and physically separated from each other. Further, the display apparatus can be manufactured by separately manufacturing the infotainment display module and the meter display module and mounting the infotainment display module on the first circuit board of the meter display module. Accordingly, the degree of freedom for design of the display apparatus according to the aforementioned configuration can be improved.

Thus, according to the aforementioned configuration, while the meter display function and the infotainment display function are configured as the modules independent of each other, the modules can be combined to configure one display apparatus. Therefore, it is possible to provide the display apparatus that is compact and high in degree of freedom for design without reducing the number of components that can be mounted on the display apparatus.

Further, according to the aforementioned configuration, the second circuit board is mounted on the first circuit board. Therefore, for example, by a heat shielding layer provided between the first circuit board and the second circuit board, heat released from the infotainment display module can be prevented from being transferred to the meter display module.

A component different from the first display panel may be disposed in a region of the first circuit board facing the second circuit board.

The component different from the first display panel may be disposed in the region of the first circuit board facing the second circuit board. Accordingly, the number of components that can be mounted on the display apparatus can be increased without increasing the size of the first circuit board.

The second circuit board may be mounted on the first circuit board such that a gap is provided between the first circuit board and the second circuit board.

The gap is provided between the first circuit board and the second circuit board. Therefore, the component can be disposed between the first circuit board and the second circuit board. In a case where, for example, the gap is not provided, the component can be mounted only in a region of the first circuit board where the second circuit board is not mounted. Therefore, it is difficult to reduce the size of the first circuit board. However, when the aforementioned configuration is used, the component can be also mounted between the first circuit board and the second circuit board. Therefore, it is possible to reduce the size of the first circuit board while increasing the region where the component can be disposed. Consequently, the size of the display apparatus can be reduced. Further, due to the gap provided between the first circuit board and the second circuit board, heat from the first circuit board and heat from the second circuit board are more easily dissipated than those in the case where the gap is not provided. Therefore, it is also possible to increase the region where the component can be disposed while maintaining performance of the display apparatus.

The second circuit may be supported by a support member disposed between the first circuit board and the second circuit board; and the support member may be electrically conductive.

The support member that support the second circuit board may be electrically conductive. Therefore, in a case where, for example, the support member is connected to a ground circuit of the first circuit board and a ground circuit of the second circuit board, the support member can function as the ground. In this case, it is unnecessary to independently ground the ground circuit of the second circuit board to the outside. Accordingly, it is easy to reduce the size of the display apparatus.

The first circuit board and the second circuit board may be connected to each other through a communication cable.

The first circuit board and the second circuit board may be connected to each other through the communication cable. Thus, the meter display module and the infotainment display module, which are the independent and separate modules respectively, can be used to easily configure the display apparatus. That is, when, for example, an adapter serving for connecting the communication cable is disposed on the second circuit board according to the position of an adapter that serves for connecting the communication cable and that is provided on the first circuit board, the first circuit board and the second circuit board can be easily electrically connected to each other. Thus, various display apparatuses can be designed by relatively freely combining the meter display module and the infotainment display module. Consequently, the degree of freedom for design of the display apparatus can be enhanced.

The first control unit may be configured to transmit information indicating a traveling state of the saddle-riding type vehicle to the second control unit.

The first control unit may be configured to transmit the information indicating the traveling state of the vehicle to the second control unit. Therefore, the second control unit can control the second display panel based on, for example, not only the information received from the portable terminal connected to the display apparatus but also the information indicating the traveling state of the vehicle. Therefore, even if the second control unit does not directly acquire the information indicating the traveling state of the vehicle from a vehicle controller mounted on the vehicle, more suitable information corresponding to the traveling state of the vehicle can be displayed on the second display panel. Therefore, versatility of the infotainment display module can be enhanced.

### BRIEF DESCRIPTION OF DRAWINGS

FIG. 1 is a view illustrating a front portion of a straddled vehicle provided with a display apparatus according to the present embodiment.
FIG. 2 is a system configuration diagram of the straddled vehicle including the display apparatus according to the present embodiment.
FIG. 3 is a view schematically illustrating the inside of the display apparatus according to the present embodiment.
FIG. 4 is a sectional view of the display apparatus according to the present embodiment.
FIG. 5 is a view schematically illustrating the inside of another display apparatus different from the display apparatus according to the present embodiment.

### DESCRIPTION OF EMBODIMENT

An embodiment of the present invention (hereinafter referred to as the present embodiment) will be described below with reference to the drawings. Dimensions of each member shown in the drawings may differ from actual dimensions of the member for convenience of explanation.

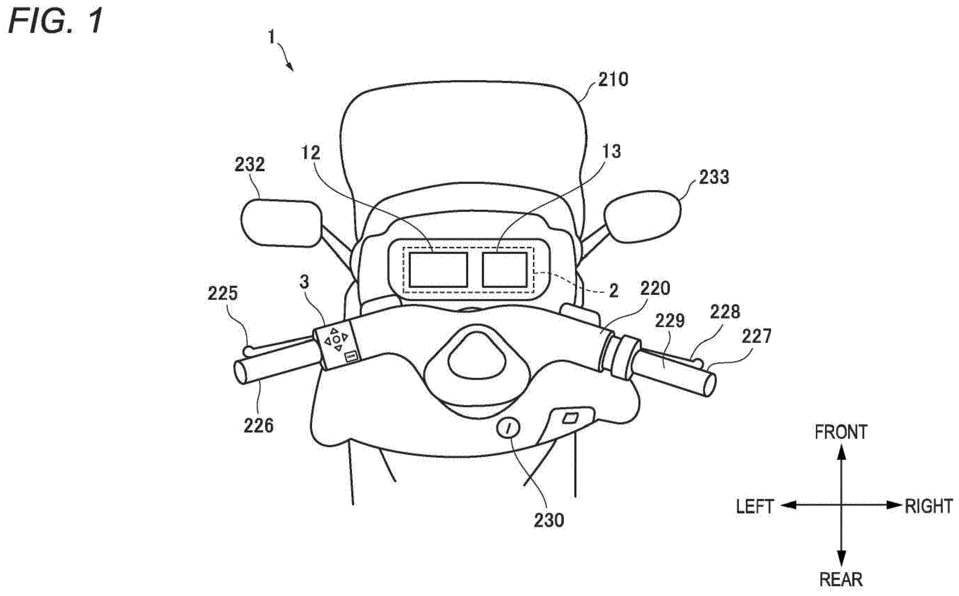

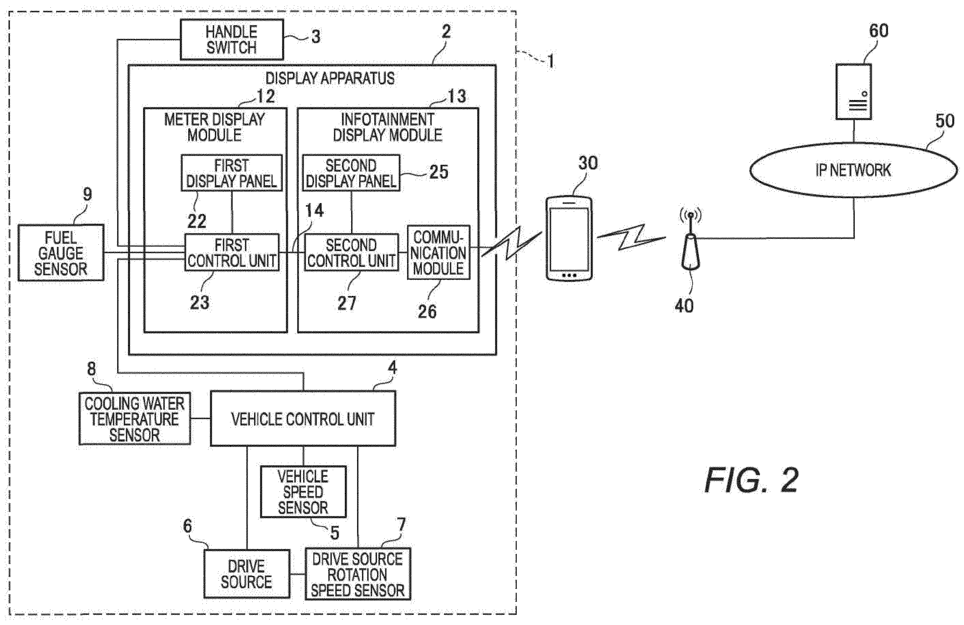

First, the configuration of a straddled vehicle 1 (hereinafter simply referred to as vehicle 1) including a display apparatus 2 according to the present embodiment will be described below with reference to FIG. 1 and FIG. 2. FIG. 1 is a view illustrating a front portion of the vehicle 1 including the display apparatus 2. FIG. 2 is a system configuration diagram of the vehicle 1 including the display apparatus 2.

As illustrated in FIG. 1, the vehicle 1 is, for example, a motorcycle that can be turned by a driver tilting a vehicle body of the motorcycle. The display apparatus 2 including a meter display module 12 for presenting traveling information of the vehicle 1 to the driver, and an infotainment display module 13 for presenting infotainment information is provided in the vehicle 1. The display apparatus 2 is provided between a windscreen 210 and a handle 220 in a front-rear direction of the vehicle 1, and provided between a left side mirror 232 and a right side mirror 233 in a left-right direction of the vehicle 1.

The handle 220 has a left handle 226 and a right handle 227. A handle switch 3 and a brake lever 225 are provided on the left handle 226. A throttle grip 229 functioning as an accelerator and a brake lever 228 are provided on the right handle 227. A main switch key 230 for turning ON or OFF drive of the vehicle 1 is provided under the handle 220.

In FIG. 1, the vehicle 1 is illustrated as a scooter type motorcycle. However, the type of the vehicle 1 is not limited to the scooter. The vehicle 1 may be any other type motorcycle than the scooter. Further, the vehicle 1 is not limited to a two-wheeled vehicle, but may be a straddled three-wheeled vehicle or four-wheeled vehicle.

Next, the system configuration diagram of the vehicle 1 will be described below with reference to FIG. 2. Only a part of constituent elements constituting the vehicle 1 are shown for convenience of explanation in FIG. 2. As illustrated in FIG. 2, the vehicle 1 includes the display apparatus 2, the handle switch 3, a vehicle control unit 4, a vehicle speed sensor 5, a drive source 6, a drive source rotation speed sensor 7, a cooling water temperature sensor 8, and a fuel gauge sensor 9.

The display apparatus 2 is configured to display traveling information of the vehicle 1 (such as speed information of the vehicle 1) after receiving the traveling information data of the vehicle 1 from the vehicle control unit 4. Further, the display apparatus 2 is configured to display infotainment information after receiving the infotainment information from a portable terminal 30 carried by the driver. Further, the display apparatus 2 may be configured to transmit, to the portable terminal 30, the traveling information data of the vehicle 1 transmitted from the vehicle control unit 4.

The display apparatus 2 includes the meter display module 12 and the infotainment display module 13. The meter display module 12 and the infotainment display module 13 are independent and separate modules. The meter display module 12 and the infotainment display module 13 are, for example, electrically connected to each other through a communication cable 14.

As illustrated in FIG. 2, the meter display module 12 includes a first display panel 22 and a first control unit 23. The meter display module 12 is configured to display a meter display picture indicating a traveling state of the vehicle 1 (such as speed or mileage of the vehicle 1) on the first display panel 22. The first display panel 22 is constituted by, for example, a digital display such as a liquid crystal display or an organic EL display, or an analog display that displays a measurement value by a pointer.

The first control unit 23 is configured to control the first display panel 22. The first control unit 23 includes a computer system including at least one processor and at least one memory, and an electronic circuit constituted by active elements and passive elements. The processor includes, for example, at least one of a CPU (Central Processing Unit), an MPU (Micro Processing Unit), and a GPU (Graphics Processing Unit). The memory includes an ROM (Read Only Memory) and an RAM (Random Access Memory). The RAM may include a VRAM (Video RAM). The ROM may include a flash memory. The processor may be configured to expand a control program stored in the ROM on the RAM and execute various processes in cooperation with the RAM. Further, the computer system may include an ASIC (Application Specific Integrated Circuit) or an FPGA (Field-Programmable Gate Array). For example, the first control unit 23 displays the meter display picture indicating the traveling information of the vehicle 1 on the first display panel 22 after receiving the traveling information from the vehicle control unit 4. Further, the first control unit 23 can also transmit the traveling information of the vehicle 1 to the infotainment display module 13.

The infotainment display module 13 includes a second display panel 25, a communication module 26, and a second control unit 27. The infotainment display module 13 is configured to display, on the second display panel 25, infotainment information transmitted from the portable terminal 30. The second display panel 25 is constituted by, for example, a liquid crystal display or an organic EL display.

The communication module 26 is communicably connected to the portable terminal 30. The communication module 26 may be configured, for example, as a wireless communication module communicably connected to the portable terminal 30 by wireless. The wireless communication module that has a high frequency circuit (RF circuit) and a transmission/reception antenna may be connected to the portable terminal 30 based on a wireless communication standard such as Wi-Fi (registered trademark) or Bluetooth (registered trademark). Further, the communication module 26 may be communicably connected to the portable terminal 30 through a wired cable such as a USB cable. In this case, the communication module 26 can be connected to the portable terminal 30, for example, based on a standard such as SDL (Smart Device Link: registered trademark).

The second control unit 27 is configured to control each of the constituent elements provided in the infotainment display module 13. The second control unit 27 may be provided with a computer system and an electronic circuit that are the same in hardware configuration as those of the first control unit 23. For example, the second control unit 27 displays infotainment information on the second display panel 25 after receiving the infotainment information from the portable terminal 30. Further, the second control unit 27 is electrically connected to the first control unit 23 of the meter display module 12 through the communication cable 14. When, for example, traveling information of the vehicle 1 is received from the first control unit 23, the second control unit 27 can display the traveling information of the vehicle 1 or the traveling information of the vehicle 1 and the infotainment information on the second display panel 25.

The portable terminal 30 is, for example, a smartphone, a cellphone, a tablet or a wearable device. The portable terminal 30 is communicably connected to a wireless base station 40 by wireless. In this respect, the portable terminal 30 may include an SIM card for data communication, and may be communicably connected to the wireless base station 40 through a 4th generation (4G) or 5th generation (5G) mobile communication system. The portable terminal 30 is connected to an external server 60 through the wireless base station 40, a core network (not shown) for portable terminals, and an IP (Internet Protocol) network 50. For example, the portable terminal 30 may transmit infotainment information (map information, music information, message information, weather information, etc.) to the communication module 26 after receiving the infotainment information from the external server 60. On the other hand, the portable terminal 30 may transmit traveling information of the vehicle 1 to the external server 60 after receiving the traveling information of the vehicle 1 from the communication module 26. Further, the portable terminal 30 may be provided with a GPS (Global Positioning System) device that receives current position information of the portable terminal 30. The portable terminal 30 may transmit, to the communication module 26, the map information received from the external server 60 and the current position information acquired by the GPS device.

The handle switch 3 is provided on the left handle 226 (see FIG. 1). The handle switch 3 is configured to transmit an operation signal to the first control unit 23 through the communication cable after generating the operation signal in accordance with an operation of the driver. The operation signal may be an analog signal or a digital signal.

The vehicle control unit 4 is configured to control traveling of the vehicle 1. In particular, the vehicle control unit 4 is configured to control the drive source 6 based on an accelerator operation signal or a brake operation signal outputted from an HMI (Human Machine Interface) of, for example, the throttle grip or one of the brake levers. The vehicle control unit 4 is constituted by, for example, at least one electronic control unit (ECU). The ECU may include a computer system including at least one processor and at least one memory, and an electronic circuit constituted by active elements and passive elements. The vehicle control unit 4 is configured to transmit a detection signal outputted from any of various sensors provided in the vehicle 1 to the first control unit 23 through a CAN (Control Area Network) communication cable.

The vehicle speed sensor 5 is configured to detect speed of the vehicle 1 and transmit a detection signal indicating the speed of the vehicle 1 to the vehicle control unit 4. The detection signal indicating the speed of the vehicle 1 may be transmitted to the vehicle control unit 4 through an ABS (Anti-lock Braking System). The drive source rotation speed sensor 7 is configured to detect rotation speed of the drive source 6 and transmit a detection signal indicating the rotation speed of the drive source 6 to the vehicle control unit 4. The drive source 6 that is configured to generate driving force of the vehicle 1 is an engine and/or a motor.

The cooling water temperature sensor 8 is configured to detect temperature of cooling water cooling the drive source 6 and transmit a detection signal indicating the temperature of the cooling water to the vehicle control unit 4. In a case where the drive source 6 is not a water-cooled engine, the cooling water temperature sensor 8 does not need to be provided in the vehicle 1. In this case, an engine temperature sensor that is configured to detect engine temperature may be provided in the vehicle 1 in place of the cooling water temperature sensor 8. The fuel gauge sensor 9 is configured to detect a remaining amount of fuel (such as a remaining amount of gasoline) of the drive source 6 and transmit a detection signal indicating the remaining amount of the fuel to the first control unit 23 through the CAN communication cable. Further, the fuel gauge sensor 9 may be configured to transmit the detection signal indicating the remaining amount of the fuel to the vehicle control unit 4. When the drive source 6 is a motor, a remaining battery level sensor that detects a remaining battery level may be provided in the vehicle 1 in place of the fuel gauge sensor 9.

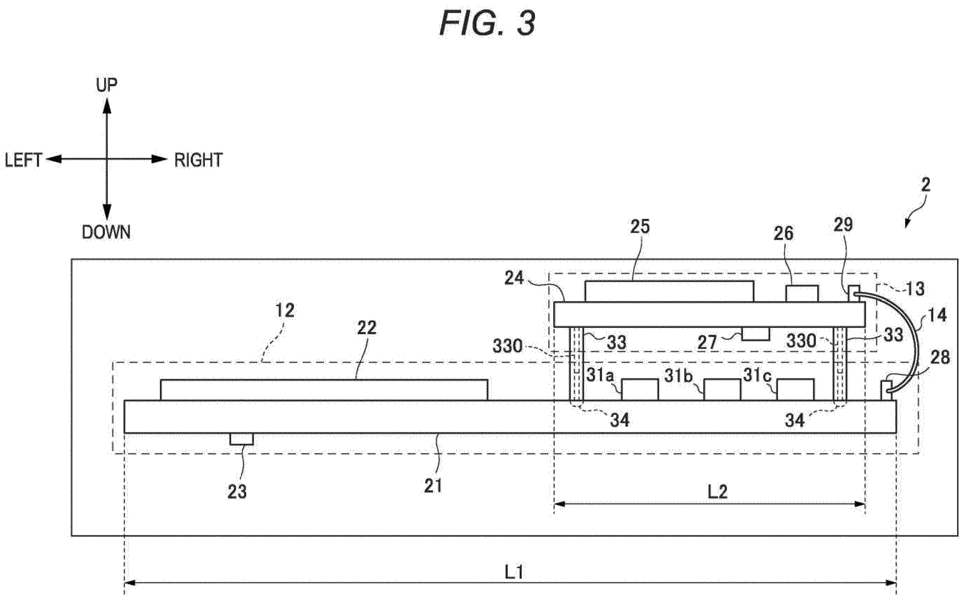

Next, structures of the meter display module 12 and the infotainment display module 13 provided in the display apparatus 2 and a positional relation between the meter display module 12 and the infotainment display module 13 will be described with reference to FIG. 3. FIG. 3 is a view schematically illustrating the inside of the display apparatus 2.

As illustrated in FIG. 3, the meter display module 12 includes a first circuit board 21. A first adapter 28 is provided on a right end portion of the first circuit board 21. In addition, the infotainment display module 13 includes a second circuit board 24. A second adaptor 29 is provided on a right end portion of the second circuit board 24. Each of the first circuit board 21 and the second circuit board 24 is a flat plate-like rigid board having a substantially rectangular outer shape. Each of the first circuit board 21 and the second circuit board 24 has a rigid insulator, a circuit pattern, and a ground circuit, and can be mounted with at least one electronic component electrically connected to the circuit pattern.

In the present embodiment, the first display panel 22, the first adaptor 28, and electronic components 31a, 31b and 31c are mounted on an upper portion of the first circuit board 21. The first control unit 23 is mounted on a lower portion of the first circuit board 21. However, some or all of the electronic components 31a, 31b and 31c do not need to be mounted on the first circuit board 21. In addition, the first control unit 23 is disposed in a region positioned under the first display panel 22. However, the first control unit 23 may be, for example, disposed in a region positioned under the electronic components 31a, 31b and 31c or on the upper portion of the first circuit board 21. Examples of each of the electronic components 31a, 31b and 31c include a capacitor, an integrated circuit, a Hall IC (Integrated Circuit), a coil, a resistor, etc.

The second display panel 25, the communication module 26, and the second adaptor 29 are mounted on an upper portion of the second circuit board 24. The second control unit 27 is mounted on a lower portion of the second circuit board 24. The second control unit 27 is disposed in a region positioned under the second display panel 25. However, the second control unit 27 may be, for example, disposed in a region positioned under the communication module 26 or on the upper portion of the second circuit board 24. Any other electronic component than these electronic components may be mounted on the second circuit board 24. Moreover, the communication module 26 may be mounted on the lower portion of the second circuit board 24.

Each of the first adapter 28 and the second adaptor 29 has a terminal into which a connector (not shown) of the communication cable 14 can be inserted. In the present embodiment, the connectors of the communication cable 14 are inserted into the terminal of the first adapter 28 and the terminal of the second adapter 29 respectively. Accordingly, the first circuit board 21 and the second circuit board 24 are electrically connected to each other through the communication cable 14. The communication cable 14 is, for example, a flexible signal cable such as a flexible flat cable.

The second circuit board 24 is mounted to be laminated on the first circuit board 21. In the present embodiment, the second circuit board 24 is supported by support members 33 disposed between the first circuit board 21 and the second circuit board 24 so that the second circuit board 24 is mounted to be laminated on the first circuit board 21. A length L2 in a longitudinal direction (left-right direction in FIG. 3) of the second circuit board 24 is shorter than a length L1 in a longitudinal direction of the first circuit board 21. Accordingly, the first circuit board 21 has a region not overlapping with the second circuit board 24 in a thickness direction (up-down direction in FIG. 3) of the first circuit board 21. In addition, the second circuit board 24 is disposed at a position not overlapping with the first display panel 22 in the thickness direction of the first circuit board 21 and at a position above the first circuit board 21. That is, the second circuit board 24 is mounted on the first circuit board 21 so that a predetermined gap is provided between the first circuit board 21 and the second circuit board 24. A height of the gap provided between the first circuit board 21 and the second circuit board 24 in the thickness direction of the first circuit board 21 is, for example, in a range of from 5 mm to 30 mm.

The gap provided between the first circuit board 21 and the second circuit board 24 is present within a region of the first circuit board 21 facing the second circuit board 24. Accordingly, heat from the first circuit board 21 and heat from the second circuit board 24 can be dissipated through the gap. Moreover, for example, in order to prevent heat released from the infotainment display module 13 from being transferred to the meter display module 12, a heat shielding layer is preferably provided between the first circuit board 21 and the second circuit board 24. Examples of the heat shielding layer include a heat shielding plate containing a synthetic resin, a metal material, a metal composite material, or the like, a pressure-sensitive adhesive sheet containing an acrylic-based component, a urethane-based component, a rubber-based component, a silicone-based component, or the like, as a main component, etc.

The first display panel 22 is disposed on the first circuit board 21 in a region not facing the second circuit board 24. On the other hand, components (the electronic components 31a, 31b and 31c) different from the first display panel 22 are disposed in the region of the first circuit board 21 facing the second circuit board 24. That is, the electronic components 31a, 31b, and 31c are disposed in the gap provided between the first circuit board 21 and the second circuit board 24.

Each of the support members 33 that is a rod-like metal member is electrically conductive. The support member 33 is internally provided with a cavity portion 330. The support member 33 is fixed on the first circuit board 21 by inserting a fixation member 34 into the cavity portion 330 through an insertion hole (not shown) provided in the first circuit board 21. For example, a screw containing a resin material or a metal material, or the like can be used as the fixation member 34. Further, an upper end of the support member 33 is in contact with the second circuit board 24, and a lower end of the support member 33 is in contact with the first circuit board 21. In the present embodiment, the support member 33 is connected to the ground circuit of the first circuit board 21 and the ground circuit of the second circuit board 24. Therefore, the support member 33 can function as the ground for the second circuit board 24.

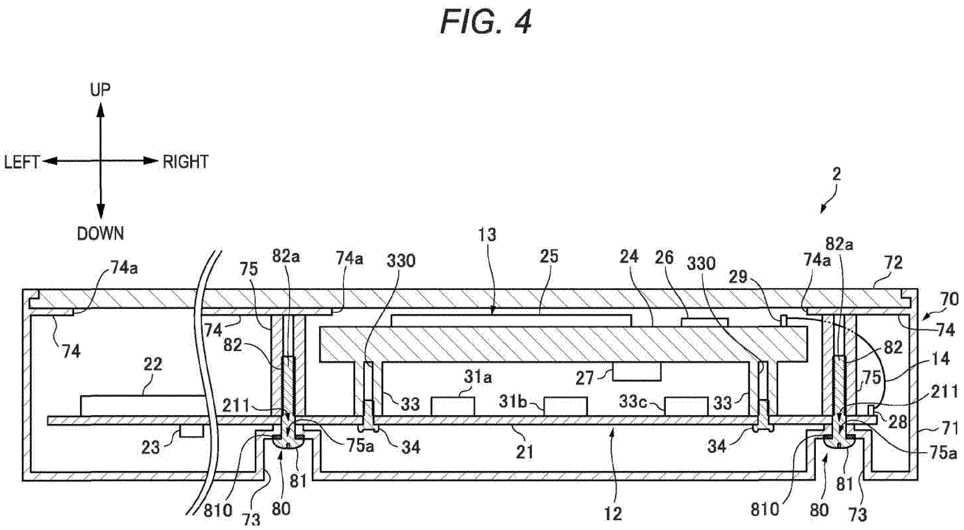

Next, an internal structure of the display apparatus 2 will be described with reference to FIG. 4. FIG. 4 is a sectional view of the display apparatus 2.

As illustrated in FIG. 4, the display apparatus 2 includes a housing portion 70. The housing portion 70 that is a box-like member having a substantially rectangular parallelepiped outer shape is disposed to cover the meter display module 12 and the infotainment display module 13. The first circuit board 21 and the second circuit board 24 are fixed to the housing portion 70 through screws 80.

The housing portion 70 includes a non-transparent portion 71 and a transparent portion 72. The non-transparent portion 71 is formed into a rectangular parallelepiped box-like shape as an outer shape, from which an upper surface is absent. The non-transparent portion 71 includes recesses 73, a support portion 74, and boss portions 75. The recesses 73 and the support portion 74 are, for example, formed out of a resin material. For example, an acrylate-based resin, an epoxy-based resin, or the like can be used as the resin material. The non-transparent portion 71 is, for example, formed out of a black resin material so that the inside of the non-transparent portion 71 cannot be visually recognized from the outside.

The recesses 73 are provided at positions facing the support portion 74. In the present embodiment, the recesses 73 are disposed under the first circuit board 21. The boss portions 75 are formed above the recesses 73, and the recesses 73 and the boss portions 75 are formed so as to be continuous to each other.

The support portion 74 is a plate-like member extending in the longitudinal direction (left-right direction in FIG. 4) of the first circuit board 21. The support portion 74 includes portions that are provided above the recesses 73 to support the first circuit board 21, the second circuit board 24, and the transparent portion 72. The support portion 74 is configured so that inner edge portions of the support portion 74 form openings 74a each of which is substantially shaped like a rectangle in top view.

The boss portions 75 can contain magnesium, aluminum, a resin, etc. The boss portions 75 are provided above the recesses 73 to extend downward from the support portion 74. Each of the boss portions 75 is configured to be provided with a substantially cylindrical insertion hole 75a through which a screw 80 can be inserted into the boss portion 75.

The transparent portion 72 is a plate-like member such as a transparent resin or glass plate, through which light can be transmitted. The transparent portion 72 is disposed to cover the openings 74a. Therefore, in the present embodiment, the transparent portion 72 is configured to transmit light emitted from each of the first display panel 22 and the second display panel 25. Therefore, for example, the driver of the vehicle 1 can visually recognize information displayed on the first display panel 22 and/or the second display panel 25 through the transparent portion 72.

The first circuit board 21 includes first retention portions 211 for retaining the first circuit board 21. In the present embodiment, each of the first retention portions 211 is an insertion hole through which a screw or the like can be inserted. The first retention portion 211 is aligned with the corresponding insertion hole 75a in the thickness direction of the first circuit board 21.

The screws 80 can be, for example, formed out of a resin material such as polycarbonate, polypropylene, polyphenylene sulfide or polyacetal, a metal material such as carbon steel, alloy steel, stainless steel or a titanium alloy, or the like. Each of the screws 80 includes a head portion 81 and a body portion 82.

The head 81 is a dome type. A contact portion 810 provided on the body portion 82 side of the head 81 is in contact with the housing portion 70. For example, to electrically connect the housing portion 70 and the first circuit board 21 to each other, the screws 80 and portions of the housing portion 70 that are in contact with the contact portions 810 are, for example, preferably plated with copper. In this case, the second circuit board 24 can be electrically connected to the ground for the vehicle 1 through the housing portion 70 and the support members 33.

The body portion 82 is substantially shaped like a column. A threaded portion 82a having a spiral pitch is provided in the body portion 82. The screw 80 is fixed with the threaded portion 82a crimped in the boss portion 75.

In the present embodiment, the screw 80 penetrates the insertion hole 75a and the first retention portion 211 to be inserted into the boss portion 75. That is, the first circuit board 21 is fixed to the housing portion 70 through the screw 80 in the first holding portion 211.

By the way, in recent years, a display portion of a display apparatus mounted on a straddled vehicle often displays not only information indicating a traveling state of the vehicle but also infotainment information. Therefore, the number of components provided in the display apparatus tends to increase. When the number of the components increases, the size of the circuit board may be increased in order to enlarge a region where the components can be mounted. When the size of the board is increased, the size of the display apparatus is also increased. As a result, the degree of freedom for design of the straddled vehicle may be decreased.

Further, in a background-art display apparatus, a display panel for displaying vehicle speed information etc. and a display panel for displaying infotainment information are designed as one module. That is, the entire module in the background-art display apparatus is newly designed according to each straddled vehicle. As a result, it often leads to an increase in the number of development steps and prolongation of a development period, so that overall manufacturing cost may increase.

To solve this problem, it was made an examination about the display apparatus that has a small number of development steps and a short development period while achieving a high degree of freedom for design. The infotainment information is information received from a communication terminal and has low relevance to the designability of the straddled vehicle in the display apparatus. Therefore, it has been noticed that the display panel for displaying the infotainment information can be also used for different vehicle types. That is, it has been noticed that, of the display panel for displaying the meter display picture and the display panel for displaying the infotainment information, which display panels have been designed as one module in the background art, the latter has high versatility. Therefore, it is an idea that the two display panels can be designed as independent modules respectively, and a display apparatus having a small number of development steps and a short development period while achieving a high degree of freedom for design can be manufactured by combining the two display modules.

According to the present embodiment, the first control unit 23 is disposed on the first circuit board 21, and the second control unit 27 is disposed on the second circuit board 24. Therefore, the meter display module 12 and the infotainment display module 13 are designed as modules independent of each other. Further, the display apparatus 2 is manufactured by separately manufacturing the infotainment display module 13 and the meter display module 12 and mounting the infotainment display module 13 on the first circuit board 21. Therefore, various display apparatuses may be manufactured by changing the combination of the infotainment display module 13 and the meter display module 12. That is, the meter display module 12 to be mounted can vary according to the vehicle model. Even in such a case, the infotainment display module 13 however does not need to be redesigned. Thus, the display apparatus 2 is an apparatus that is compact and can secure a high degree of freedom for design without reducing the number of components that can be mounted on the display apparatus 2.

Further, the second circuit board 24 is mounted on the first circuit board 21. Accordingly, in the case where, for example, a heat shielding layer is provided between the first circuit board 21 and the second circuit board 24, heat released from the infotainment display module 13 can be also prevented from being transferred to the meter display module 12.

Further, according to the present embodiment, components (the electronic components 31a, 31b and 31c) different from the first display panel 22 are disposed in the region of the first circuit board 21 facing the second circuit board 24. Thus, in the case of the display apparatus 2, the components can be mounted in the region of the first circuit board 21 facing the second circuit board 24 even if the size of the first circuit board 21 is not increased. Accordingly, the number of the components that can be mounted can be increased.

Further, according to the present embodiment, the gap is provided between the first circuit board 21 and the second circuit board 24. Further, the electronic components can be also disposed in the region of the first circuit board 21 facing the second circuit board 24. Accordingly, the number of the components that can be mounted on the first circuit board 21 is larger than that in the case where the gap is not provided. Therefore, it is possible to reduce the size of the first circuit board 21 while increasing the region where the components can be disposed. Thus, it is possible to reduce the size of the display apparatus 2. Further, the gap is provided between the first circuit board 21 and the second circuit board 24. Therefore, heat from the first circuit board 21 and heat from the second circuit board 24 are more easily dissipated than those in the case where the gap is not provided. Therefore, it is also possible to increase the region where the components can be disposed while maintaining performance of the display apparatus 2.

Further, according to the present embodiment, the support members 33 are electrically conductive. Therefore, in the case where the support members 33 are connected to the ground circuit of the first circuit board 21 and the ground circuit of the second circuit board 24, the support members 33 function as the ground. In this case, it is unnecessary to independently ground the ground circuit of the second circuit board 24 to the outside. Accordingly, it is easy to reduce the size of the display apparatus 2.

Further, according to the present embodiment, since the first circuit board 21 and the second circuit board 24 are connected to each other through the communication cable 14, the meter display module 12 and the infotainment display module 13, which are independent and separate modules, can be used to configure one display apparatus 2. For example, if the second adapter 29 is disposed on the second circuit board 24 according to the position of the first adapter 28 provided on the first circuit board 21, the first circuit board 21 and the second circuit board 24 can be electrically connected to each other. Accordingly, the meter display module 12 and the infotainment display module 13 can be easily combined. Thus, various display apparatuses 2 can be designed by relatively freely combining the meter display module 12 and the infotainment display module 13. Therefore, the degree of freedom for design of the display apparatus 2 is improved.

Further, according to the present embodiment, the first control unit 23 can transmit information indicating the traveling state of the vehicle 1 to the second control unit 27. In this case, the second control unit 27 can control the second display panel 25 based on not only the information received from the portable terminal 30 but also the information indicating the traveling state of the vehicle 1. Therefore, even if the second control unit 27 does not directly acquire the information indicating the traveling state of the vehicle 1 from the vehicle 1, more suitable information corresponding to the traveling state of the vehicle 1 can be displayed on the second display panel 25. Accordingly, versatility of the infotainment display module 13 can be enhanced.

### (Example of Another Display Apparatus)

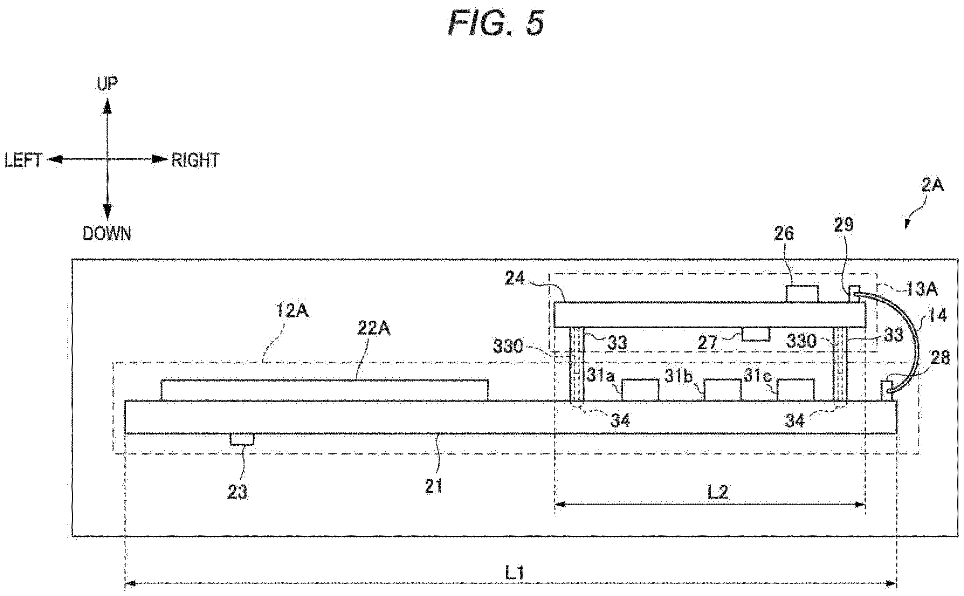

Next, another display apparatus 2A different from the display apparatus 2 will be described with reference to FIG. 5. FIG. 5 is a view schematically illustrating the inside of the display apparatus 2A.

The display apparatus 2A is different from the display apparatus 2 in that a second display panel 25 is not provided and a meter display picture and infotainment information can be displayed on a first display panel 22A. In description of the display apparatus 2A, the same configuration as that of the display apparatus 2 will be described using the same reference signs as those used in the description of the display apparatus 2, and duplicate description thereof will be omitted.

As illustrated in FIG. 5, the display apparatus 2A includes a meter display module 12A and an infotainment acquisition module 13A. The first display panel 22A is mounted in the meter display module 12A in place of the first display panel 22. Further, the infotainment acquisition module 13A has a configuration in which the second display panel 25 has been removed from the infotainment display module 13 of the display apparatus 2.

The first display panel 22A is configured to display the meter display picture and the infotainment information. In the display apparatus 2A, the meter display picture and the infotainment information can be simultaneously displayed on the first display panel 22A in one case, or only the meter display picture can be displayed on the first display panel 22A in another case. A second control unit 27 provided in the display apparatus 2A can transmit infotainment information acquired from a portable terminal 30 through a communication module 26 to a first control unit 23, for example, through a communication cable 14.

In the present embodiment, the meter display module 12 and the infotainment display module 13 are electrically connected to each other through the communication cable 14. However, the present embodiment is not limited thereto. For example, the meter display module 12 and the infotainment display module 13 may be connected to each other by wireless.

In the present embodiment, the second circuit board 24 is mounted on the first circuit board 21 so that the predetermined gap is provided between the first circuit board 21 and the second circuit board 24. However, the present embodiment is limited thereto. For example, the second circuit board 24 may be mounted on the first circuit board 21 without the predetermined gap provided between the first circuit board 21 and the second circuit board 24.

### REFERENCE SIGNS LIST

1: Straddled vehicle (vehicle)
2: Display apparatus
3: Handle switch
4: Vehicle control unit
5: Vehicle speed sensor
6: Drive source
7: Drive source rotation speed sensor
8: Cooling water temperature sensor
9: Fuel gauge sensor
12, 12A: Meter display module
13: Infotainment display module
13A: Infotainment acquisition module
14: Communication cable
21: First circuit board
22, 22A: First display panel
23: First control unit
24: Second circuit board
25: Second display panel
26: Communication module
27: Second control unit
28: First adaptor
29: Second adaptor
30: Portable terminal
31a, 31b, 31c: Electronic component
33: Support member
34: Fixation member
40: Wireless base station
50: Network
60: External server
70: Housing portion
71: Non-transparent portion
72: Transparent portion
73: Recess
74: Support portion
74a: Opening portion
75: Boss portion
75a: Insertion hole
80: Screw
81: Head portion
82: Body portion
82a: Threaded portion
210: Windscreen
211: First retention portion
220: Handle
225: Brake lever
226: Left handle
227: Right handle
228: Brake lever
229: Throttle grip
230: Main switch key
232: Left side mirror
233: Right side mirror
330: Cavity portion
810: Contact portion

## Claims

1. A display apparatus (2) which is to be mounted on a straddled vehicle (1) and communicably connectable to a portable terminal (30),
the display apparatus (2) comprising:
a meter display module (12) comprising:
a first circuit board (21);
a first display panel (22) disposed on the first circuit board (21) and configured to display a meter display picture indicating a traveling state of the straddled vehicle (1); and
a first control unit (23) disposed on the first circuit board (21) and configured to control the first display panel (22); and
an infotainment display module (13) comprising:
a second circuit board (24);
a second display panel (25) disposed on the second circuit board (24) and configured to display infotainment information transmitted from the portable terminal (30); and
a second control unit (27) disposed on the second circuit board (24) and
configured to control the second display panel (25), and
a communication module (26) disposed on the second circuit board (24) and
communicably connectable to the portable terminal (30), **characterized in that** the second circuit board (24) is mounted on the first circuit board (21).

2. The display apparatus (2) according to claim 1, **characterized in that** a component (31a, 31b, 31c) different from the first display panel (22) is disposed in a region of the first circuit board (21) facing the second circuit board (24).

3. The display apparatus (2) according to claim 1 or 2, **characterized in that** the second circuit board (24) is mounted on the first circuit board (21) such that a gap is provided between the first circuit board (21) and the second circuit board (24).

4. The display apparatus (2) according to any one of claims 1 to 3, **characterized in that** the second circuit board (24) is supported by a support member (33) disposed between the first circuit board (21) and the second circuit board (24); and
the support member (33) is electrically conductive.

5. The display apparatus (2) according to any one of claims 1 to 4, **characterized in that** the first circuit board (21) and the second circuit board (24) are connected to each other through a communication cable (14).

6. The display apparatus (2) according to any one of claims 1 to 5, **characterized in that** the first control unit (23) is configured to transmit information indicating a traveling state of the straddled vehicle (1) to the second control unit (27).

7. A straddled vehicle (1) having a display apparatus (2) according to at least one of the claims 1 to 6 mounted thereon.

8. A display means comprising a display apparatus (2) according to at least one of the claims 1 to 6 and a portable terminal (30), the display apparatus (2) is communicably connectable to the portable terminal (30).

## Patentansprüche

1. Ein Anzeigegerät (2), das auf einem Spreiz-Sitz-Fahrzeug (1) zu montieren ist und mit einem tragbaren Endgerät (30) kommunizierend verbindbar ist,
das Anzeigegerät (2) umfasst:
ein Instrumenten-Anzeigemodul (12), das umfasst:
eine erste Leiterplatte (21);
ein erstes Anzeigefeld (22), das auf der ersten Leiterplatte (21) angeordnet ist, und konfiguriert ist, um ein Instrumentenanzeigebild anzuzeigen, das einen Fahrzustand des Spreiz-Sitz-Fahrzeugs (1) angibt; und
eine erste Steuereinheit (23), die auf der ersten Leiterplatte (21) angeordnet ist, und konfiguriert ist, um das erste Anzeigefeld (22) zu steuern; und
ein Infotainment-Anzeigemodul (13) das umfasst:
eine zweite Leiterplatte (24);
ein zweites Anzeigefeld (25), das auf der zweiten Leiterplatte (24) angeordnet ist, und konfiguriert ist, um Infotainment-Informationen, die von dem tragbaren Endgerät (30) übertragen sind, anzuzeigen; und
eine zweite Steuereinheit (27), die auf der zweiten Leiterplatte (24) angeordnet ist, und konfiguriert ist, um das zweite Anzeigefeld (25) zu steuern, und
ein Kommunikationsmodul (26), das auf der zweiten Leiterplatte (24) angeordnet ist und mit dem tragbaren Endgerät (30) kommunizierend verbunden werden kann, **dadurch gekennzeichnet, dass** die zweite Leiterplatte (24) auf der ersten Leiterplatte (21) montiert ist.

2. Das Anzeigegerät (2) gemäß Anspruch 1, **dadurch gekennzeichnet, dass** ein Bauteil (31a, 31b, 31c), das von dem ersten Anzeigefeld (22) verschieden ist, in einem Bereich der ersten Leiterplatte (21) angeordnet ist, welcher der zweiten Leiterplatte (24) zugewandt ist.

3. Das Anzeigegerät (2) gemäß Anspruch 1 oder 2, **dadurch gekennzeichnet, dass** die zweite Leiterplatte (24) auf der ersten Leiterplatte (21) angebracht ist, so dass ein Spalt zwischen der ersten Leiterplatte (21) und der zweiten Leiterplatte (24) vorgesehen ist.

4. Das Anzeigegerät (2) gemäß irgendeinem der Ansprüche 1 bis 3, **dadurch gekennzeichnet, dass** die zweite Leiterplatte (24) durch ein Lagerelement (33) gelagert ist, das zwischen der ersten Leiterplatte (21) und der zweiten Leiterplatte (24) angeordnet ist; und
das Lagerelement (33) elektrisch leitfähig ist.

5. Das Anzeigegerät (2) gemäß irgendeinem der Ansprüche 1 bis 4, **dadurch gekennzeichnet, dass** die erste Leiterplatte (21) und die zweite Leiterplatte (24) über ein Kommunikationskabel (14) miteinander verbunden sind.

6. Das Anzeigegerät (2) gemäß irgendeinem der Ansprüche 1 bis 5, **dadurch gekennzeichnet, dass** die erste Steuereinheit (23) konfiguriert ist, um Informationen, die einen Fahrzustand des Spreiz-Sitz-Fahrzeugs (1) anzeigen, an die zweite Steuereinheit (27) zu übermitteln.

7. Ein Spreiz-Sitz-Fahrzeug (1), das ein Anzeigegerät (2) gemäß zumindest einem der Ansprüche 1 bis 6 darauf montiert hat.

8. Eine Anzeigeeinrichtung, die ein Anzeigegerät (2) gemäß zumindest einem der Ansprüche 1 bis 6 und ein tragbares Endgerät (30) umfasst, das Anzeigegerät (2) ist dem tragbaren Endgerät (30) kommunizierend verbindbar ist.

## Revendications

1. Appareil d'affichage (2) destiné à être monté sur un véhicule à enfourcher (1) et connectable en communication avec un terminal portable (30), l'appareil d'affichage (2) comprenant :
un module d'affichage de compteur (12) comprenant :
un premier circuit imprimé (21) ;
un premier panneau d'affichage (22) disposé sur le premier circuit imprimé (21) et configuré pour afficher une image d'affichage de compteur indiquant un état de déplacement du véhicule à enfourcher (1) ; et
une première unité de contrôle (23) disposée sur le premier circuit imprimé (21) et configurée pour contrôler le premier panneau d'affichage (22) ; et
un module d'affichage d'infodivertissement (13) comprenant :
un deuxième circuit imprimé (24) ;
un deuxième panneau d'affichage (25) disposé sur le deuxième circuit imprimé (24) et configuré pour afficher de l'information d'infodivertissement transmise par le terminal portable (30) ; et
une deuxième unité de contrôle (27) disposée sur le deuxième circuit imprimé (24) et configurée pour contrôler le deuxième panneau d'affichage (25), et
un module de communication (26) disposé sur le deuxième circuit imprimé (24) et connectable en communication avec le terminal portable (30),
**caractérisé en ce que** le deuxième circuit imprimé (24) est monté sur le premier circuit imprimé (21).

2. Appareil d'affichage (2) selon la revendication 1,
**caractérisé en ce qu'**un composant (31a, 31b, 31c) différent du premier panneau d'affichage (22) est disposé dans une région du premier circuit imprimé (21) qui fait face au deuxième circuit imprimé (24).

3. Appareil d'affichage (2) selon la revendication 1 ou 2,
**caractérisé en ce que** le deuxième circuit imprimé (24) est monté sur le premier circuit imprimé (21) de telle sorte qu'un intervalle est pourvu entre le premier circuit imprimé (21) et le deuxième circuit imprimé (24).

4. Appareil d'affichage (2) selon l'une quelconque des revendications 1 à 3,
**caractérisé en ce que** le deuxième circuit imprimé (24) est supporté par un élément de support (33) disposé entre le premier circuit imprimé (21) et le deuxième circuit imprimé (24); et **en ce que** l'élément de support (33) est électroconducteur.

5. Appareil d'affichage (2) selon l'une quelconque des revendications 1 à 4,
**caractérisé en ce que** le premier circuit imprimé (21) et le deuxième circuit imprimé (24) sont connectés entre eux via un câble de communication (14).

6. Appareil d'affichage (2) selon l'une quelconque des revendications 1 à 5,
**caractérisé en ce que** la première unité de contrôle (23) est configurée pour transmettre de l'information indiquant un état de déplacement du véhicule à enfourcher (1) à la deuxième unité de contrôle (27).

7. Véhicule à enfourcher (1) sur lequel est monté un appareil d'affichage (2) selon au moins l'une des revendications 1 à 6.

8. Moyen d'affichage comprenant un appareil d'affichage (2) selon au moins l'une des revendications 1 à 6 et un terminal portable (30), dans lequel l'appareil d'affichage (2) est connectable en communication avec le terminal portable (30).
